# EUROPEAN PATENT SPECIFICATION

(11) **EP 1 104 034 B1**
(45) Date of publication and mention of the grant of the patent: **24.07.2002**
(21) Application number: 99830730.0
(22) Date of filing: 25.11.1999
(51) Int. Cl.: H01L 41/09

(54) **Roof-shaped piezoelectric actuator**
Dachförmiger piezoelektrischer Antrieb
Organe d'actionnement pièzoélectrique en forme de toit

(43) Date of publication of application: 30.05.2001
(73) Proprietor: C.R.F. Società Consortile per Azioni, 10043 Orbassano (Torino) (IT)
(72) Inventor: Pizzi, Marco, C.R.F. Società Consortile per Azioni, 10043 Orbassano (IT); Sinesi, Sabino, C.R.F. Soc. Consortile per Azioni, 10043 Orbassano (IT); Lambertini, Vito C.R.F. S.p.A., 10043 Orbassano (IT); Perlo, Piero, C.R.F. S.p.A., 10043 Orbassano (IT)
(74) Representative: Notaro, Giancarlo

(56) References cited:
- DE-C- 19 636 827

## Description

The present invention relates to piezoelectric actuators and aims to the object of providing an actuator of this type which at the same time has a relatively simple and inexpensive structure having a reduced bulk and adapted to be used efficiently in various micro-electronic and automotive applications (such as for moving needles of dashboard instruments, rear-view mirrors and adaptive lighting systems in general, i.e. systems having variable performances).

In view of achieving this object, the invention provides a piezoelectric actuator, comprising a metal base blade, including a strip portion defined by two parallel cuts formed in the base blade, said strip portion being deformed out of the plane of the base blade so as to assume a roof-shaped configuration, with two inclined portions, converging towards a common apex starting from the base blade, said piezoelectric actuator further comprising a piezoelectric layer covering the base blade and the two inclined portions, and two electrodes applied on the two said inclined portions, as well as electric supply means adapted to supply an electric voltage separately to the electrodes applied to the two said inclined portions.

In a preferred embodiment, the above mentioned electric supply means are adapted to supply alternated voltages which are out of phase by 90 degrees relative to each other to the two electrodes associated with the two inclined portions of the actuator. In this manner, the apex of the actuator makes an oscillatory movement having one component parallel to the plane of the base blade, and can act as driving member in respect of a driven body which is in friction contact with said apex.

The invention will be now described with reference to the annexed drawings, given purely by way of non limiting example, in which:
figure 1 is a cross-sectional view of an actuator according to the invention,
figure 2 is a perspective diagrammatic view of the actuator of figure 1,
figure 3 is a diagrammatic view of a variant of figure 1,
figure 4 shows two diagrams of the voltage supplied to the actuator according to the invention,
figure 5 shows the principle of operation of the actuator according to the invention,
figure 6 shows two diagrams which show the movement of the two inclined portions of the actuator according to the invention, and
figure 7 is a diagram showing the path of the apex of the roof-shaped actuator according to the invention.

With reference to the drawings, the actuator comprises a base blade 1, made of steel, having a thickness in the order of hundredths of millimeter, in which two parallel cuts 2 are formed to define a strip portion 3 which is deformed out of the plane of blade 1 so as to assume a roof-shaped configuration, with two inclined portions 4, 5 converging relative to each other towards a common apex 6 starting from two bending edges 7, 8 of the base blade 1.

The entire surface of the base blade 1 and inclined portions 4, 5 is coated with a layer 9 of piezoelectric material, applied such as by screen-printing or dipping, having a thickness of a few tens of microns. On the two inclined portions 4, 5 two respective electrodes 10, 11 are then applied by evaporation, whose supply is controlled by electric supply means which are diagrammatically designated by 12. Preferably, the entire surface is then covered by a protective layer (not shown in the drawings). On the apex 6 of the roof-like portion 3 a coating of a material having a high friction coefficient is then preferably applied, such as by evaporation, or any other technique. The apex 6 is intended to act as a driving member for a driven body (not shown) resting above apex 6.

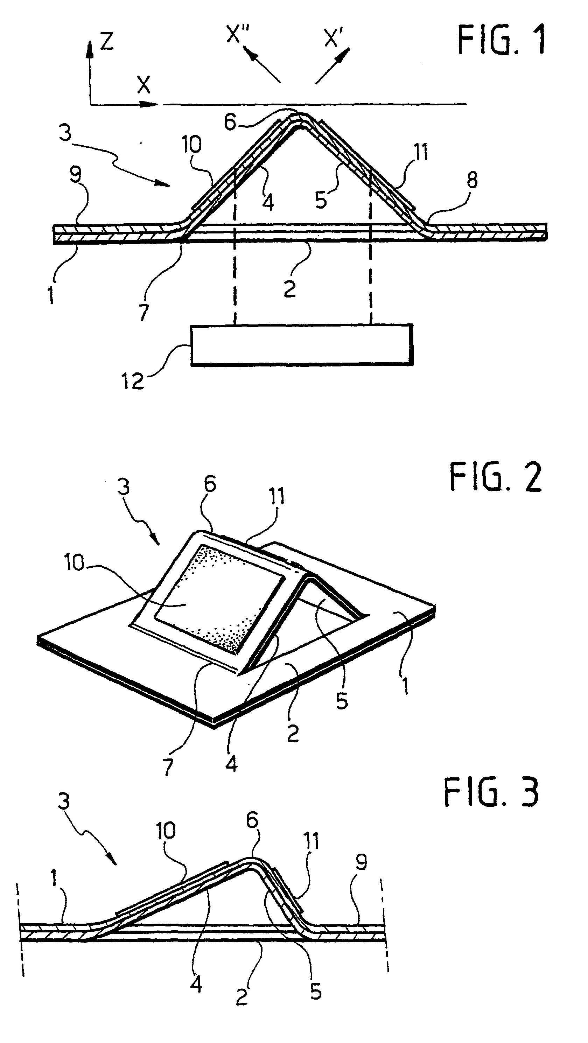

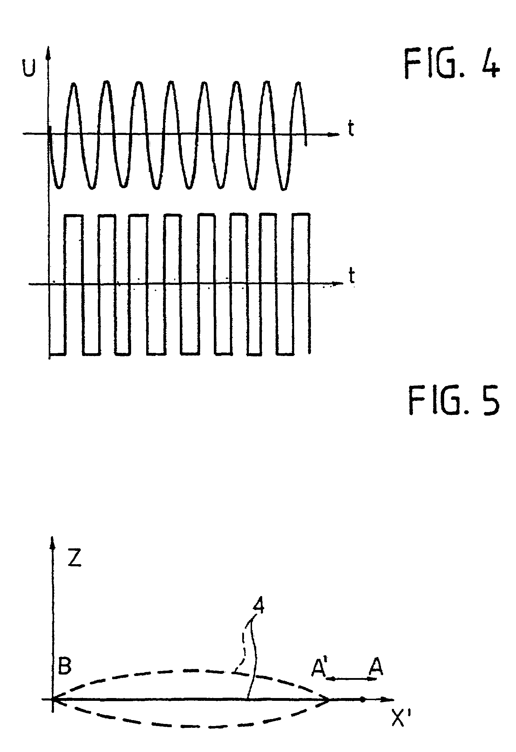

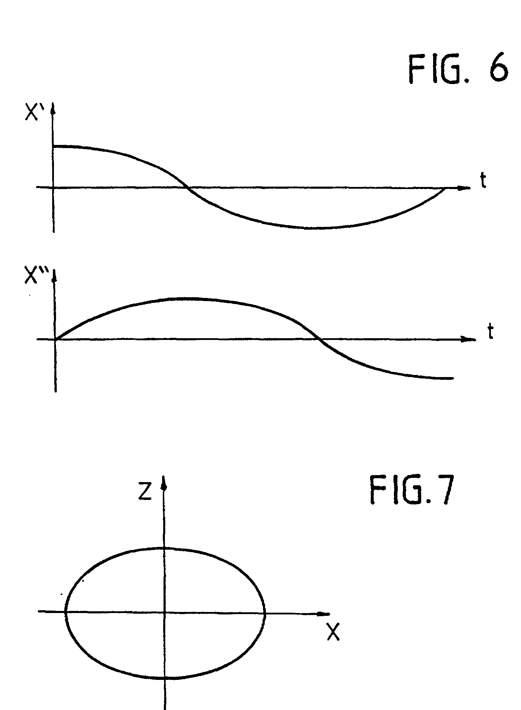

The supply means 12 are adapted to supply a sinusoidal or square electric voltage (see figure 4) between base 1 and electrode 10, having an amplitude of a few tens of volts. The supply means 12 are further adapted to supply a similar voltage, but out of phase by 90 degrees, to electrode 11. As a result of these supply, the piezoelectric layer associated with the two inclined portions 4, 5 is deflected cyclically. For example with reference to figure 5, the bending movement of the inclined portion 4 is shown therein relative to a reference system (X', Z'), where X' is oriented as shown in figure 1 parallel to the inclined portion 4. The deformed condition of the inclined portion 4 is shown in figure 5 by dotted lines, above or below the abscissa line, depending upon whether the supply voltage is positive or negative. Because of this deformation, apex 6 would move alternatively between the positions indicated by A and A' in figure 5, the position of point 7 being indicated by B. Naturally, the same movement could be shown with reference to the inclined portion 5. Therefore, by shifting the voltage signals fed to the two electrodes 10, 11 by 90 degrees, the movements shown in figure 6 are obtained. The upper part of this figure shows the movement of apex 6 in the direction X' with respect to the edge 7, whereas the lower part of this figure shows the movement of apex 6 with respect to point 8, along the direction X'' shown in figure 1. The combination of these movements causes a helipsoidal movement (figure 7) of apex 6 relative to the reference system (X, Z).

Therefore, if a driven member is supported above apex 6, the horizontal component of the movement can be exploited to repeatedly impart a force to the driven member, which is driven by friction.

Naturally, is possible to provide a single base blade 1 with a plurality of roof-like portions 3, arranged side-by-side and/or in line or also oriented along different directions relative to each other, so as to increase the power and/or the degrees of freedom of the movement.
Figure 3 shows a variant in which the roof-like portion has an asymmetric shape. By exploiting the asymmetry of the roof-like configuration, or by differently shifting the voltage signals supplied to the electrodes, or also by providing different thickness for the two inclined portions, it is possible to obtain different paths of the movement generated by the actuator.

## Claims

1. Piezoelectric actuator, comprising a metal base blade (1), including a strip portion (3) defined by two parallel cuts (2) formed in the base blade (1), said strip portion being deformed out of the plane of the base blade (1) so as to assume a roof-like configuration, with two inclined portions (4, 5) converging towards a common apex (6) starting from the base blade (1), said piezoelectric actuator further comprising a piezoelectric layer covering the base blade (1) and the two inclined portions (4, 5), two electrodes (10, 11) applied to the two said inclined portions (4, 5), and electric supply means (12) adapted to separately apply an electric voltage to said electrodes (10, 11).

2. Actuator according to claim 1, **characterised in that** said electric supply means (12) are adapted to supply alternated voltages which are out of phase by 90 degrees relative to each other to the two said electrodes (10, 11).

3. Actuator according to claim 1, **characterised in that** in a same base blade (1) there are formed a plurality of roof portions (3) arranged side-by-side and/or in line and/or oriented along different directions relative to each other, to increase the power and the degrees of freadom of movement of the actuator.

4. Actuator according to claim 1, **characterised in that** the base blade (1) has a thickness in the order of hundredths of millimeter.

5. Actuator according to claim 1, **characterised in that** the piezoelectric layer (9) is applied by screen-printing or dipping.

6. Actuator according to claim 1, **characterised in that** the two said electrodes (10, 11) are applied by evaporation, screen-printing or dipping.

7. Actuator according to claim 1, **characterised in that** said apex (6) acting as driving member, is provided with a coating of a material having a high friction coefficient.

8. Actuator according to claim 1, **characterised in that** said roof-like portion (3) has a symmetric shape.

9. Actuator according to claim 1, **characterised in that** said roof-like portion (3) has an asymmetric shape.

10. Actuator according to claim 1, **characterised in that** said inclined portions (4, 5) have different thickness.

## Patentansprüche

1. Piezoelektrischer Antrieb, umfassend ein Basisblatt aus Metall (1), das einen Streifenbereich (3) einschließt, der durch zwei parallele, in dem Basisblatt (1) angebrachte Einschnitte (2) festgelegt wird, wobei der genannte Streifenbereich aus der Ebene des Basisblattes (1) heraus gebogen ist, so daß er eine dachförmige Konfiguration einnimmt, mit zwei geneigten Bereichen (4, 5), die in Richtung auf einen gemeinsamen Scheitelpunkt (6) konvergieren, ausgehend vom Basisblatt (1), wobei der genannte piezoelektrische Antrieb außerdem eine piezoelektrische, das Basisblatt (1) und die zwei geneigten Bereiche (4, 5) bedeckende Schicht, zwei an den zwei genannten geneigten Bereichen (4, 5) angebrachte Elektroden (10, 11), und Stromversorgungsmittel (12), welche dafür geeignet sind, an die genannten Elektroden (10, 11) getrennt eine elektrische Spannung anzulegen, umfaßt.

2. Antrieb nach Anspruch 1, **dadurch gekennzeichnet, daß** die genannten Stromversorgungsmittel (12) geeignet sind, Wechselspannungen, die relativ zueinander um 90 Grad phasenverschoben sind, an die beiden genannten Elektroden (10, 11) zu liefern.

3. Antrieb nach Anspruch 1, **dadurch gekennzeichnet, daß** in ein- und demselben Basisblatt (1) eine Vielzahl von Dachbereichen (3) ausgebildet sind, die nebeneinander und/oder in einer Reihe und/oder entlang verschiedener Richtungen relativ zueinander angeordnet sind, um die Kraft und die Freiheitsgrade der Bewegung des Antriebes zu erhöhen.

4. Antrieb nach Anspruch 1, **dadurch gekennzeichnet, daß** das Basisblatt (1) eine Dicke in der Größenordnung von Hundertstelmillimetern hat.

5. Antrieb nach Anspruch 1, **dadurch gekennzeichnet, daß** die piezolelektrische Schicht (9) durch Siebdruck oder Eintauchen aufgebracht ist.

6. Antrieb nach Anspruch 1, **dadurch gekennzeichnet, daß** die zwei genannten Elektroden (10, 11) durch Bedampfung, Siebdruck oder Eintauchen angebracht sind.

7. Antrieb nach Anspruch 1, **dadurch gekennzeichnet, daß** der genannte, als Antriebsglied wirkende Scheitel (6) mit einer Beschichtung aus einem Material ausgestattet ist, das einen hohen Reibungskoeffizienten aufweist.

8. Antrieb nach Anspruch 1, **dadurch gekennzeichnet, daß** der genannte dachförmige Bereich (3) eine symmetrische Gestalt hat.

9. Antrieb nach Anspruch 1, **dadurch gekennzeichnet, daß** der genannte dachförmige Bereich (3) eine asymmetrische Gestalt hat.

10. Antrieb nach Anspruch 1, **dadurch gekennzeichnet, daß** die genannten geneigten Bereiche (4, 5) unterschiedliche Dicke aufweisen.

## Revendications

1. Organe d'actionnement piézo-électrique, comportant une feuille de base métallique (1), comprenant une partie sous forme de bande (3) obtenue par deux découpes parallèles (2) pratiquées dans la feuille de base (1), ladite partie en forme de bande étant déformée hors du plan de la feuille de base (1) de manière à prendre une configuration sous forme de toit, avec deux parties inclinées (4, 5) convergeant vers un sommet commun (6) à partir de la feuille de base (1), ledit organe d'actionnement piézo-électrique comprenant en outre une couche piézo-électrique recouvrant la feuille de base (1) et les deux parties inclinées (4, 5), deux électrodes (10, 11) appliquées aux deux dites parties inclinées (4, 5), et des moyens d'alimentation électriques (12) aptes à appliquer séparément une tension électrique auxdites électrodes (10, 11).

2. Organe d'actionnement selon la revendication 1, **caractérisé en ce que** lesdits moyens d'alimentation électrique (12) sont aptes à délivrer des tensions alternatives déphasées de 90° l'une par rapport à l'autre aux deux dites électrodes (10, 11).

3. Organe d'actionnement selon la revendication 1, **caractérisé en ce que** dans une même feuille de base (1) sont formées une pluralité de parties en forme de toit (3) disposées côte à côte et/ou alignées et/ou orientées selon différentes directions les unes par rapport aux autres, afin d'augmenter la puissance et le degré de liberté de mouvement de l'organe d'actionnement.

4. Organe d'actionnement selon la revendication 1, **caractérisé en ce que** la feuille de base (1) possède une épaisseur de l'ordre de plusieurs centaines de mm.

5. Organe d'actionnement selon la revendication 1, **caractérisé en ce que** la couche piézo-électrique (9) est appliquée par sérigraphie ou immersion.

6. Organe d'actionnement selon la revendication 1, **caractérisé en ce que** les deux dites électrodes (10, 11) sont appliquées par évaporation, sérigraphie ou immersion.

7. Organe d'actionnement selon la revendication 1, **caractérisé en ce que** ledit sommet (6), agissant en tant qu'élément d'entraînement, est revêtu d'un matériau ayant un coefficient de friction élevé.

8. Organe d'actionnement selon la revendication 1, **caractérisé en ce que** ladite partie en forme de toit (3) présente une forme symétrique.

9. Organe d'actionnement selon la revendication 1, **caractérisé en ce que** ladite partie sous forme de toit (3) présente une forme asymétrique.

10. Organe d'actionnement selon la revendication 1, **caractérisé en ce que** lesdites parties inclinées (4, 5) ont une épaisseur différente.
